# EUROPEAN PATENT APPLICATION

(11) **EP 1 930 775 A1**
(43) Date of publication of application: **11.06.2008**
(21) Application number: 05781041.8
(22) Date of filing: 29.08.2005
(51) Int. Cl.: G03F 7/32, H01L 21/027

(54) **RINSING LIQUID FOR LITHOGRAPHY AND METHOD FOR RESIST PATTERN FORMATION**

(30) Priority: 01.09.2004 JP 2004254940
(71) Applicant: TOKYO OHKA KOGYO CO., LTD., Kawasaki-shi, Kanagawa 211-0012 (JP)
(72) Inventor: SAWADA, Yoshihiro; c/o TOKYO OHKA KOGYO CO.,, Kana gawa; 2110012 (JP); WAKIYA, Kazumasa; c/o TOKYO OHKA KOGYO CO.,, Kanag awa; 2110012 (JP); KOSHIYAMA, Jun; c/o TOKYO OHKA KOGYO CO.,, Kanagaw a; 2110012 (JP); MIYAMOTO, Atsushi; c/o TOKYO OHKA KOGYO CO.,, Kawasaki-shi, Kana gawa; 2110012 (JP); TAJIMA, Hidekazu; c/o TOKYO OHKA KOGYO CO.,, Kanag awa; 2110012 (JP)
(74) Representative: Hayes, Adrian Chetwynd
(86) International application number: PCT/JP2005/015630
(87) International publication number: WO 2006/025303

(57) **Abstract**

This invention provides a novel rinsing liquid for lithography, which, for a photoresist pattern, can reduce surface defects, the so-called defects, without sacrificing the quality of the product, and, at the same time, can impart resistance to electron beam irradiation to suppress the shrinkage of the resist pattern, and a method for resist pattern formation using the same. A resist pattern is formed by preparing a rinsing liquid for lithography comprising an aqueous solution containing (A) a water-soluble and/or alkali-soluble polymer having a nitrogen atom in its molecular structure and (B) at least one member selected from aliphatic alcohols and alkyletherification products thereof, and then carrying out (1) the step of providing a photoresist film on a substrate, (2) the step of selectively exposing the photoresist film thorough a mask pattern, (3) the step of heat-treating the exposed photoresist film, (4) the step of carrying out alkali development, and (5) the step of treating the developed film with the rinsing liquid for lithography.

## Description

### TECHNICAL FIELD

The present invention relates to a rinse solution for lithography which is, when brought into contact with a resist after a pattern-forming light-exposure followed by a development treatment, capable of decreasing the contact angle to the developer solution or water while maintaining the uniformity within the resist surface, suppressing occurrence of microbubbles and enabling uniform coating even over a large size wafer, for example, of around 300 mm and, as a result, so as to suppress the defects after the rinse treatment or to improve the electron beam resistance so as to be effective for suppressing shrinkage of the resist pattern caused by the electron beam irradiation as well as to a method for the formation of a resist pattern by using the same.

### BACKGROUND TECHNOLOGY

Along with the trend in recent years toward compactness and high integration of semiconductor devices, the light sources for the fine working thereof are also under a trend of shift to shorter wavelength ones from traditional UV light to the g-line (436 nm) capable of forming a resist pattern of higher pattern resolution, from the g-line to the i-line (365 nm) and from the i-line to the KrF excimer laser (248 nm) to accomplish shorter and shorter wavelengths leading to the current ArF excimer laser (193 nm), F₂ excimer laser (157 nm) and further electron beams such as EB and EUV shifter as a major current while developments of the process and resist materials are under progress at a high pace in order to comply with these short-wavelength light sources.

Conventional photoresists are required to have: for instance, improved sensitivity, pattern resolution, heat resistance, focusing depth latitude, cross sectional profile of a resist pattern and aging stability resulting in the deterioration of the shape of the resist pattern due to contamination with amine and the like in a period between light exposure and post-exposure baking (PEB) and controlled substrate dependency which changes are caused in the cross sectional profile of the resist pattern depending on various coating films provided on the silicon wafer such as insulating films including silicon nitride (SiN) films, semiconductor films including polycrystalline silicon (poly-Si) films and metallic films including titanium nitride (TiN) films. These requirements have been solved to some extent, but a defect which is a particularly important issue has many problems remaining unsolved.

The defect means a mismatch between a resist pattern and a photomask pattern, which is detected when a resist pattern after having been developed is examined from right above with a surface defect observation instrument, for instance, the mismatch like a difference between shapes of the patterns, occurrence of scums and contaminants, irregular coloring and coalescence between the patterns and the like. The yield of the semiconductor devices decreases as the number of defects increases so that, even though the resist has the adequate resist characteristics as described above, defects make it difficult for the semiconductor devices to be effectively mass produced, while the problems thereof remain unsolved.

While a variety of factors could be assumable as responsible for these defects, some of them include occurrence of microbubbles during development and re-deposition of insoluble matters once removed by rinse.

As a method for decreasing such defects, a proposal is made (JP2002-148816A) to improve the formulation of the positive-working resist composition *per se* to be used for the pattern-formation but such a modification of the composition is undesirable because a modification of the process per se must be accompanied.

Further, a method is proposed (JP2001-23893A) for coating, in the course of resist-pattern forming, with a defect treating agent having a hydrophobic group and a hydrophilic group or, namely, with a surfactant but this method has defects that the top portion of the resist pattern is rounded to degrade the orthogonality of the cross section and, in addition, film thickness reduction of the resist layer is caused by this treatment. In a semiconductor manufacturing plant, besides, a developer solution is usually supplied through a collective pipeline during the development treatment so that, when using various resists, it is necessary to change the treatment agent in correspondence to each resist, and to clean the inside of the pipeline after each run. Consequently, this method is unsuitable.

Furthermore, there is known (JP2001-159824A) a method for decreasing the defects in the developing step of lithography by using a developer solution containing an organic base free from metallic ions and containing a nonionic surfactant as a principal ingredient but no sufficient defect-decreasing effect can be obtained with an additional aforementioned inconvenience accompanying the changes in handling in a plant.

On the other hand, a method is known (JP2002-323774A) for decreasing the defects by conducting a treatment prior to the post-exposure baking treatment by using an aqueous solution of pH 3.5 or lower containing a low-volatile aromatic sulfonic acid and having a molecular weight of at least 200 but no satisfactory defects decreasing effect suitable for industrialization can still be reached.

### DISCLOSURE OF THE INVENTION

The present invention has been completed under these circumstances with an object to provide a novel rinse solution for lithography used for decreasing the surface defects or so-called defects never with a decrease in the product quality of photoresist patterns and also suppressing shrinkage of a resist pattern by imparting resistance against electron beam irradiation as well as to provide a resist pattern forming method by using the same.

The inventors have continued extensive investigations in order to develop a treatment solution capable of decreasing the defects in a resist pattern and improving the yield by imparting electron beam resistance to the resist without decreasing the performance for rinse and, as a result thereof, have reached a discovery that an aqueous solution containing (A) a water-soluble and/or alkali-soluble polymer having a nitrogen atom in the molecular structure and (B) at least one kind selected from aliphatic alcohols and alkyl-etherified compounds thereof is suitable for uniform coating over a wafer surface to be effective for decreasing the defects and for imparting electron beam resistance to the resist so that, when a resist film after the alkali development treatment in conducting formation of a resist pattern is treated with the aforementioned solution, a resist pattern with a good profile can be obtained and the defects can be decreased without film thickness reduction along with suppression of shrinkage of the resist pattern due to electron beam irradiation leading to the present invention on the base thereof.

Thus, the present invention provides a rinse solution for lithography comprising an aqueous solution containing:
(A) a water-soluble and/or alkali-soluble polymer having a nitrogen atom in the molecular structure; and
(B) at least one kind selected from aliphatic alcohols and alkyl-etherified compounds thereof;
   as well as a resist pattern-forming method characterized by comprising:
   (1) a step of providing a photoresist film on a substrate;
   (2) a step of selective light-exposure of the said photoresist film through a photomask pattern;
   (3) a step of subjecting the aforementioned photoresist film after the light-exposure treatment to a post-exposure baking treatment (referred to hereinbelow as PEB treatment);
   (4) a step of subjecting the aforementioned photoresist film after the PEB treatment to an alkali-development treatment; and
   (5) a step of treating the aforementioned photoresist film after the alkali-development treatment with the aforementioned rinse solution for lithography.

It is necessary that the water-soluble and/or alkali-soluble polymer used as the component (A) in the present invention contains a nitrogen atom in the molecular structure. The nitrogen atom can be contained in the functional molecular chain of a polymer but is preferably contained in the side chain as a nitrogen-containing substituent.

The polymer containing a nitrogen atom in the functional molecular chain is exemplified, for example, by a polymer of lower alkyleneimines or a copolymer of a lower alkyleneimine and another monomer capable of forming a water-soluble polymer by itself, of which polyethyleneimine is particularly preferred in respect of easy availability thereof.

The polyethyleneimine can be easily produced, for example, by polymerization of ethyleneimine in the presence of an acidic catalyst such as carbon dioxide, chlorine, hydrogen bromide, p-toluenesulfonic acid and the like and it is available as a commercial product.

The polymer containing nitrogen-containing substituent groups on the side chains is exemplified by the polymers of an unsaturated hydrocarbon having an amino group or a substituted amino group or a nitrogen-containing heterocyclic group. The polymer implied here means a polymer or a copolymer. The polymer of an unsubstituted hydrocarbon having an amino group is exemplified, for example, by polyallylamines. The polyallylamine can readily be obtained, for example, by heating allylamine hydrochloride in the presence of a radical polymerization initiator.

The particularly preferable polymer containing a nitrogen-containing substituent group used in the present invention is a water-soluble and/or alkali-soluble polymer having monomeric units containing a nitrogen-containing heterocyclic group represented by the general formula, 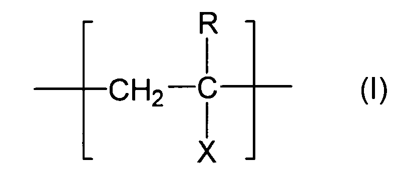 (R in the formula is a hydrogen atom or a methyl group and X is a nitrogen-containing heterocyclic group).

Examples of the nitrogen-containing heterocyclic group denoted by X in the above given general formula (I) include, for example, a pyrrolyl group, imidazolyl group, imidazolynyl group, pyrazolyl group, thiazolyl group, oxazolyl group, isoxazolyl group, pyridyl group, pyrazyl group, pyrimidyl group, pyridazyl group, triazolyl group, indolyl group, quinolyl group, morpholino group, butyrolactam group, caprolactam group and the like and also include other nitrogen-containing heterocyclic groups.

The bonding position of these heterocyclic groups to the base carbon chain is not particularly limitative and can be at a nitrogen atom or can be at a carbon atom.

The polymer containing a nitrogen-containing heterocyclic group which is used in the present invention can be a copolymer of: a monomeric unit having a nitrogen-containing heterocyclic group expressed by the above given general formula (I), and a monomeric unit derived from a monomer capable of singly forming a water-soluble polymer.

The water-soluble and/or alkali-soluble polymer having a monomeric unit containing a nitrogen-containing heterocyclic group can be prepared, for example, by polymerizing a monomer having a nitrogen-containing heterocyclic group expressed by the general formula 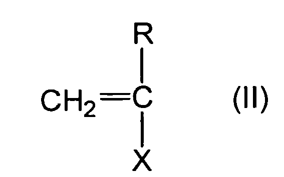 (R and X in the formula have the same meanings as above) or a mixture of the monomer and a monomer capable of singly forming a water-soluble polymer. The polymerization in this case means homopolymerization or copolymerization.

Particularly preferable ones among the monomers expressed by the above given general formula (II) include vinyl imidazole, vinyl imidazoline, vinyl pyridine, vinyl pyrrolidone, vinyl morpholine and vinyl caprolactam.

The polymerization of a monomer having a nitrogen-containing heterocyclic group or a mixture of the monomer and a monomer capable of singly polymerizing to form a water-soluble polymer can be performed according to known methods such as the solution polymerization method and suspension polymerization method.

The above-mentioned monomers capable of singly forming a water-soluble polymer include, for example, vinyl acetate (forming a vinyl alcohol unit by hydrolysis), monomers containing no nitrogen atoms such as hydroxyalkyl esters of acrylic acid or methacrylic acid and the like. These monomers can be used singly or can be used as a combination of two kinds or more.

The proportion in this case between the monomer having a nitrogen-containing heterocyclic group and the monomer capable of singly forming a water-soluble polymer is selected in the range of 10:0 to 1:9 or, preferably, 9:1 to 2:8 by mass. When the proportion of the monomer having a nitrogen-containing heterocyclic group is smaller than above, the adsorbing performance onto the resist surface is decreased so that the desired characteristic or, namely, pattern-falling preventing power is decreased. The mass-average molecular weight of this polymer is selected in the range of 500 to 1500000 or, preferably, 1000 to 50000. It is particularly preferable that this polymer contains a cationic monomer.

Such a copolymer is known and marketed from, for example, BASF Corp. [product names LUVITEC VP155 K72W and Sokalan HP56] and polyvinylimidazoline is marketed from TOSOH CORP.

The rinse solution of the present invention for lithography is employed for the treatment of the substrate which is at the stage after alkali development of a resist film on the substrate having been subjected to an image-forming light exposure. This treatment is undertaken by dipping the substrate bearing the resist film in this treatment solution or by coating or spraying the resist film with this rinse solution. The concentration of the water-soluble and/or alkali-soluble polymers in this rinse solution is selected in the range of 0.001 to 10% by mass or, preferably, 0.01 to 3% by mass. A length of time of 1 to 30 seconds would be sufficient for the treatment with this rinse solution.

The component (B), i.e. at least one kind selected from aliphatic alcohols and alkyl-etherified compounds thereof, in the present invention acts to defoam the microbubbles generated in coating with the rinse solution and, even in coating of a large-size wafer, acts to form a uniform coating film by causing dispersion or diffusion of the component (A), i.e. the water-soluble and/or alkali-soluble polymer, in the rinse solution onto the surface.

The aliphatic alcohol or an alkyl-etherified compound thereof to be used includes alkanols and alkyl-etherified compounds thereof such as, for example, methanol, ethanol, 1-propanol, 2-propanol, n-butyl alcohol, isobutyl alcohol, *tert*-butyl alcohol, diethyl ether, and ethyl propyl ether, compounds in which a part or all of the hydrogen atoms are substituted by fluorine atoms such as trifluoroethanol, dichloroethanol and the like, alkylene glycols and alkyl-etherified compounds thereof such as, for example, 1,2-eththanediol, 1,3-propanediol, 1,4-butanediol, 2,3-butanediol and1,5-pentanediol and their monomethyl ethers, monoethyl ethers and monopropyl ethers as well as polyalkyleneglycols and their alkyl-etherified compounds such as, for example, diethyleneglycol, triethyleneglycol, tetraethyleneglycol, polyethyleneglycols having a molecular weight of 100 to 10000, dipropyleneglycol, tripropyleneglycol, polyethyleneoxides and polypropyleneoxides having a molecular weight of 100 to 10000 and poly(ethyleneoxide/propyleneoxide) having a molecular weight of 100 to 10000 and methyl ethers, ethyl ethers and propyl ethers thereof, glycerin and others.

They can be used singly or can be used as a combination of two kinds or more.

This component (B) is used in a concentration in the range of 0.0001 to 15% by mass or, preferably, 0.005 to 10% by mass on the overall amount of the rinse solution. When a polyalkyleneglycol is used, in particular, a sufficient effect can be noted even with 500 ppm or lower.

The rinse solution of the present invention for lithography is prepared by dissolving a water-soluble and/or alkali-soluble polymer and an aliphatic alcohol or an alkyl-etherified compound thereof described above in water in a specified proportion.

It is optional, if so desired, that this rinse solution is adjusted in acidity by the addition of an acid or adjusted in basicity of pH 8 or higher by the addition of an amine compound or a quaternary ammonium hydroxide. Addition of these compounds is effective for preventing degradation of the composition over time.

A known surfactant can be contained in this rinse solution, if so desired, with an object of improvement of the coating behavior thereof or others. Examples of such a surfactant include N-octyl-2-pyrrolidone and the like.

Since, by this treatment, a decrease is caused in the contact angle at the liquid interface on the resist pattern surface down to 40 degrees or, preferably, 30 degrees or lower, an effect is obtained for enhancement of the cleaning efficiency on the resist pattern surface or, namely, an effect is obtained for decreasing the count number of defects as a whole, irrespective of the mode. Since the rinse solution of the present invention works to decrease the contact angle on the resist pattern surface, furthermore, an effect is obtained that the defects due to re-precipitation can be further decreased by preventing re-deposition of the resist materials once removed from the resist pattern and floating in the rinse solution. And, this contact angle is kept constant during the rinse treatment with pure water optionally undertaken according to need succeedingly.

The above-described rinse solution is employed satisfactorily in the resist pattern formation by the use of a photoresist film, in particular. The method of resist pattern formation in this case consists of the steps (1) through (5) given below.

Firstly, step (1) is a step for the formation of a photoresist film on a substrate.

The substrate usable is usually a silicon wafer. Known ones can be used as the photoresist composition for the formation of the photoresist film.

In this step (1), a photoresist film is formed on a substrate such as a silicon wafer which is coated with a solution of a photoresist composition prepared in the aforementioned manner by a spinner and the like followed by a drying treatment.

In step (2), nextly, the photoresist film formed in step (1) is subjected to a selective light-exposure treatment through a photomask pattern to form a latent image followed by step (3) in which a PEB treatment is undertaken. These step (2) and step (3) are carried out in just the same manner as in the prior art method for the formation of a resist pattern by using a resist.

The photoresist film after the PEB treatment in this way is then subjected in step (4) to an alkali-development treatment. This alkali-development treatment is carried out, for example, by using an aqueous solution of tetramethyl ammonium hydroxide (referred to hereinbelow as an aqueous TMAH solution) in a concentration of 1 to 10% by mass or, preferably, in a concentration of 2.38% by mass.

In step (5) undertaken to follow this step (4), the photoresist film after the alkali development is treated with the aforementioned rinse solution for lithography.

Since semiconductor devices are usually under mass production where throughput is one of important factors, the treatment time should preferably be as short as possible. This treatment time is selected in the range of 1 to 30 seconds. By this treatment, the contact angle of the resist pattern surface against the solution is decreased usually to 40 degrees or smaller.

When the component (A) contained in the rinse solution in this step (5) is a polymer of allylamine, an advantage is obtained by a further shortening of the aforementioned treatment time.

Thus, when rinse is conducted with a rinse solution for lithography containing a polyallylamine as the component (A), an effect is obtained that the water-releasability or, namely, water shake-off can be improved in the optionally undertaken subsequent treatment with a second rinse solution containing a water-soluble fluorocarbon compound for improving the contact angle on the resist surface against pure water. The polyallylamine in this case should preferably have a molecular weight in the range of 1000 to 60,000. When the content of the polylallylamine in this rinse solution is increased to some extent, the shake-off time of around 10 seconds in the use of another water-soluble and/or alkali-soluble polymer can be shortened to about 3 seconds or, namely, to about one third.

The treatment in step (5) with the rinse solution for lithography is conducted, for example, by coating or spraying the resist pattern surface with the rinse solution or by dipping the resist pattern in the rinse solution but it is advantageous to conduct coating, for example, by rotary coating for which no separate step is required in the production line of the semiconductor devices for accomplishing a high throughput.

In the resist pattern forming method of the present invention, it is optional to add a step (6), if so desired, which is a step for rinse with pure water after undertaking the step (5).

In the resist pattern formation, usually, one of the reasons leading to defects is that an alkali-insoluble ingredient in the photoresist composition precipitates out in the course of water rinse to follow the alkali development to be deposited on the surface of the photoresist film after formation of the resist pattern. When, in the method of the present invention, on the other hand, a treatment is undertaken with the inventive rinse solution for lithography after development, the contact angle is decreased or, in particular, when a solution of the water-soluble and/or alkali-soluble polymer of the present invention is used for a means of decreasing the contact angle, the resist pattern surface is imparted with a characteristic property of hydrophilicity so that re-deposition of the alkali-dissolved matter in the photoresist onto the resist pattern surface can be suppressed giving rise to an assumption that a particularly great decrease is caused in the re-deposition-based defects.

While, as is mentioned before, the resist pattern surface after the treatment according to the inventive method has a contact angle as low as 40 degrees or lower or, in a desirable case, as low as 30 degrees or lower against pure water, it is possible to regain a high contact angle of 70 degrees or higher against pure water by a further treatment with a rinse solution containing a fluorine compound soluble in an alcoholic solvent, for example, including a water-soluble fluorocarbon compound. An advantage is obtained by undertaking such a treatment that high-quality products can be manufactured by effectively preventing the pattern fallings.

### BEST MODE FOR CARRYING OUT THE INVENTION

In the following, a description is given on the best mode for practicing the present invention by way of Examples but the present invention is never limited by these examples.

### Reference Example

A 6-inch (152.4 mm) silicon wafer was coated with an antireflection film material (a product by Brewer Science, Inc., product name ARC 29A) and subjected to a heat treatment at 215°C for 60 seconds to form an antireflection film of 77 nm film thickness.

In the next place, this antireflection film was coated with a positive-working photoresist (a product by Tokyo Ohka Kogyo Co., product name TARF-P6111) on a spinner rotating at 2000 rpm taking 90 seconds to form a resist film of 18 nm film thickness immediately followed by a development treatment with a 2.38% by mass aqueous solution of tetramethylammonium hydroxide at 23 °C taking 60 seconds to prepare a sample for the treatment.

### Example 1

A rinse solution for lithography (No. 1), which was an aqueous solution of a water-soluble polymer (mass-average molecular weight 10,000) prepared by copolymerizing vinyl pyrrolidone and vinyl imidazoline in a mass proportion of 1:1 in a concentration of 0.1 % by mass and 3 kinds of rinse solutions for lithography (No. 2 to No. 4) by the admixing of an aliphatic alcohol indicated in Table 1 to the rinse solution No. 1 in a concentration of 1% by mass were prepared.

In the next place, the samples for treatment obtained in Reference Example were coated with the above-mentioned rinse solutions for lithography by using a spinner at 2000 rpm for 6 seconds followed by rinse with pure water at 500 rpm for 3 seconds.

Each of the samples obtained in this way was subjected to the measurement of the contact angles (10.0 seconds) on the peripheral portion, center portion and intermediate portion of the sample by using a contact angle tester (a product by Kyowa Interface Science Co., product name CA-X150). The results are shown in Table 1.

**Table 1**

| No. | Aliphatic alcohol | Contact angle (10.0 seconds) | | |
|---|---|---|---|---|
| | | Peripheral portion | Intermediate portion | Center portion |
| 1 | None | 25.2 | 21.2 | 23.5 |
| 2 | Isopropanol | 23.3 | 23.3 | 23.6 |
| 3 | Glycerin | 21.7 | 21.5 | 21.2 |
| 4 | Trifluoroethanol | 21.7 | 21.4 | 22.1 |

When a rinse solution with admixture of an aliphatic alcohol was employed, the contact angle of the rinse solution was uniform in each case within the wafer surface. In accordance therewith, furthermore, the effect of rinse washing was uniform within the wafer surface.

### Example 2

The same aqueous solution of the water-soluble polymer as used in Example 1 was admixed with isopropanol in a concentration of 1% by mass, 5% by mass or 10% by mass to prepare 3 kinds of rinse solutions for lithography.

In the next place, the samples for treatment obtained in Reference Example were subjected to a treatment in the same manner as in Example 1 with the rinse solutions including 3 kinds with admixture of isopropanol and one without admixture of isopropanol.

The thus obtained samples were subjected to the determination of the numbers of the defects by using a surface defects observing apparatus (a product by KLA Tencor Corp., product name KLA-2131) and the respective relative numbers obtained without admixture of isopropanol being taken as 100 are shown in Table 2.

**Table 2**

| No. | Concentration of isopropanol (% by mass) | Relative numbers of defects |
|---|---|---|
| 1 | 0 | 100 |
| 2 | 1 | 75 |
| 3 | 5 | 69 |
| 4 | 10 | 63 |

A decrease was noted in the number of the defects as the admixing amount of the aliphatic alcohol was increased.

### Example 3

The relative numbers of defects were obtained in the same manner as in Example 2 by using, as the aliphatic alcohol, isopropanol, a polyethyleneoxide (a product by Takemoto Oil & Fat Co., product name Pionine MP-400, mass-average molecular weight 400) and a poly(ethyleneoxide/propyleneoxide) (a product by Takemoto Oil & Fat Co, product name Pionine P-1028-P, mass-average molecular weight 3000) each in a concentration of 1% by mass. Note that the number of the defects in the absence of any admixed aliphatic alcohol (1200) was used as the base. The results are shown in Table 3.

**Table 3**

| No. | Type of aliphatic alcohol | Relative numbers of defects |
|---|---|---|
| 1 | Isopropanol | 62.5 |
| 2 | Polyethyleneoxide | 60.0 |
| 3 | Poly(ethyleneoxide/propyleneoxide) | 33.3 |
| 4 | Isopropanol + polyethyleneoxide | 37.5 |
| 5 | Isopropanol + poly(ethyleneoxide/propyleneoxide) | 25.0 |
| Control | None | 100 |

A decrease was effected in the number of defects by the admixture of an aliphatic alcohol.

### INDUSTRIAL UTILIZABILITY

By using the rinse solution of the present invention, the contact angle against pure water can be decreased to 40 degrees or lower so that an improvement can be accomplished in the contacting efficiency with a water-base treatment agent and, in addition, even in the treatment of a large-size wafer, the effective ingredients in the rinse solution act as being uniformly distributed over the whole wafer surface so as to exhibit an advantage that prevention can be effected against quality degradation caused by the occurrence of microbubbles. Besides, the electron beam resistance of the photoresist is improved so as to suppress the shrinkage of the resist pattern due to electron beam irradiation so as to enable to keep a high precision of the products.

Accordingly, the present invention is utilizable in the manufacture of semiconductor devices such as LSIs, ULSIs and others by using the lithographic method.

## Claims

1. A rinse solution for lithography comprising an aqueous solution containing
(A) a water-soluble and/or alkali-soluble polymer having a nitrogen atom in the molecular structure, and
(B) at least one kind selected from aliphatic alcohols and alkyl-etherified compounds thereof.

2. The rinse solution for lithography described in Claim 1 wherein the component (A) is a water-soluble and/or alkali-soluble polymer having a nitrogen-containing heterocyclic group.

3. The rinse solution for lithography described in Claim 2 wherein the water-soluble and/or alkali-soluble polymer having a nitrogen-containing heterocyclic group is a water-soluble and/or alkali-soluble polymer containing a structural unit represented by the general formula 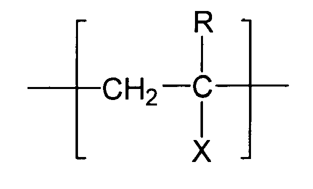 (R in the formula is a hydrogen atom or a methyl group and X is a nitrogen-containing heterocyclic group).

4. The rinse solution for lithography described in Claim 3 wherein the water-soluble and/or alkali-soluble polymer having a nitrogen-containing heterocyclic group is a polymer containing at least one kind of the monomeric units derived from vinyl imidazole or vinyl imidazoline as the structural units.

5. The rinse solution for lithography described in Claim 2 wherein the water-soluble and/or alkali-soluble polymer having a nitrogen-containing heterocyclic group is a copolymer containing the monomeric units represented by 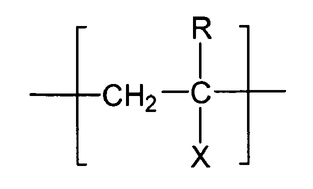 and the monomeric units derived from at least one kind selected from vinyl alcohol and hydroxyalkyl esters of acrylic acid or methacrylic acid.

6. The rinse solution for lithography described in Claim 2 wherein the water-soluble and/or alkali-soluble polymer having a nitrogen-containing heterocyclic group has a mass-average molecular weight from 500 to 1500000.

7. The rinse solution for lithography described in Claim 1 wherein the component (A) is contained in a concentration in the range from 0.001 to 10% by mass.

8. The rinse solution for lithography described in Claim 1 wherein the aliphatic alcohol and an alkyl-etherified compound thereof as the component (B) are each at least one kind selected from alkanols or alkyl-etherified compounds thereof, alkyleneglycols or alkyl-etherified compounds thereof, polyalkyleneglycols and alkyl-etherified compounds thereof and glycerin.

9. The rinse solution for lithography described in Claim 8 wherein the alkanol is at least one kind selected from methanol, ethanol, 1-propanol, 2-propanol, n-butyl alcohol, isobutyl alcohol and *tert*-butyl alcohol and the compounds derived by substitution of fluorine atoms for a part or all of the hydrogen atoms therein.

10. The rinse solution for lithography described in Claim 8 wherein the alkyleneglycol or an alkyl-etherified compound thereof is at least one kind selected from 1,2-ethanediol, 1,3-propanediol, 1,4-butanediol, 2,3-butanediol and 1,5-pentanediol, monomethyl, monoethyl or monopropyl ether thereof and glycerin.

11. The rinse solution for lithography described in Claim 8 wherein the polyalkyleneglycol or an alkyl-etherified compound thereof is at least one kind selected from diethyleneglycol, triethyleneglycol, tetraethyleneglycol, polyethyleneglycol, dipropyleneglycol, tripropyleneglycol, polyethyleneoxide, polypropyleneoxide and poly(ethyleneoxide/propyleneoxide) and methyl-, ethyl- or propyl-etherified compounds thereof.

12. The rinse solution for lithography described in Claim 1 wherein the component (B) is contained in a concentration in the range from 0.0001 to 15% by mass.

13. A method for the formation of a resist pattern which comprises conducting:
(1) a step of providing a photoresist film on a substrate;
(2) a step of subjecting the said photoresist film to a selective light-exposure treatment through a photomask pattern;
(3) a step of subjecting the said photoresist film after the light-exposure treatment to a post-exposure baking (PEB) treatment;
(4) a step of subjecting the said photoresist film after the PEB treatment to alkali development; and
(5) a step of treatment of the said photoresist film after the alkali development with the rinse solution for lithography described in any of Claims 1 to 12.

14. The method for the formation of a resist pattern described in Claim 13 wherein the step (5) is followed by a step (6) of rinse treatment by using pure water.

## Amended claims

### Amended claims under Art. 19.1 PCT

**1.** A rinse solution for lithography comprising an aqueous solution containing
(A) a water-soluble and/or alkali-soluble polymer having a nitrogen atom in the molecular structure, and
(B) at least one kind selected from aliphatic alcohols and alkyl-etherified compounds thereof.

**2.** The rinse solution for lithography described in Claim 1 wherein the component (A) is a water-soluble and/or alkali-soluble polymer having a nitrogen-containing heterocyclic group.

**3.** The rinse solution for lithography described in Claim 2 wherein the water-soluble and/or alkali-soluble polymer having a nitrogen-containing heterocyclic group is a water-soluble and/or alkali-soluble polymer containing a structural unit represented by the general formula 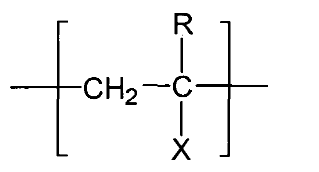 (R in the formula is a hydrogen atom or a methyl group and X is a nitrogen-containing heterocyclic group).

**4.** The rinse solution for lithography described in Claim 3 wherein the water-soluble and/or alkali-soluble polymer having a nitrogen-containing heterocyclic group is a polymer containing at least one kind of the monomeric units derived from vinyl imidazole or vinyl imidazoline as the structural units.

**5.** (Amended) The rinse solution for lithography described in Claim 2 wherein the water-soluble and/or alkali-soluble polymer having a nitrogen-containing heterocyclic group is a copolymer containing the monomeric units represented by 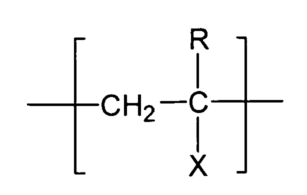 (R in the formula is a hydrogen atom or a methyl group and X is a nitrogen-containing heterocyclic group)
and the monomeric units derived from at least one kind selected from vinyl alcohol and hydroxyalkyl esters of acrylic acid or methacrylic acid.

**6.** The rinse solution for lithography described in Claim 2 wherein the water-soluble and/or alkali-soluble polymer having a nitrogen-containing heterocyclic group has a mass-average molecular weight from 500 to 1500000.

**7.** The rinse solution for lithography described in Claim 1 wherein the component (A) is contained in a concentration in the range from 0.001 to 10% by mass.

**8.** The rinse solution for lithography described in Claim 1 wherein the aliphatic alcohol and an alkyl-etherified compound thereof as the component (B) are each at least one kind selected from alkanols or alkyl-etherified compounds thereof, alkyleneglycols or alkyl-etherified compounds thereof, polyalkyleneglycols and alkyl-etherified compounds thereof and glycerin.

**9.** The rinse solution for lithography described in Claim 8 wherein the alkanol is at least one kind selected from methanol, ethanol, 1-propanol, 2-propanol, n-butyl alcohol, isobutyl alcohol and *tert*-butyl alcohol and the compounds derived by substitution of fluorine atoms for a part or all of the hydrogen atoms therein.

**10.** The rinse solution for lithography described in Claim 8 wherein the alkyleneglycol or an alkyl-etherified compound thereof is at least one kind selected from 1,2-ethanediol, 1,3-propanediol, 1,4-butanediol, 2,3-butanediol and 1,5-pentanediol, monomethyl, monoethyl or monopropyl ether thereof and glycerin.
